# EUROPÄISCHE PATENTSCHRIFT

(11) **EP 3 374 161 B1**
(45) Veröffentlichungstag und Bekanntmachung des Hinweises auf die Patenterteilung: **02.09.2020**
(21) Anmeldenummer: 16815853.3
(22) Anmeldetag: 20.12.2016
(51) Int. Cl.: B29C 64/153, B29C 64/393, B33Y 50/02

(54) **VORRICHTUNG UND VERFAHREN ZUM KALIBRIEREN EINER VORRICHTUNG ZUM GENERATIVEN HERSTELLEN EINES DREIDIMENSIONALEN OBJEKTS**
DEVICE AND METHOD FOR CALIBRATING A DEVICE FOR THE GENERATIVE PRODUCTION OF A THREE-DIMENSIONAL OBJECT
DISPOSITIF ET PROCÉDÉ D'ÉTALONNAGE D'UN DISPOSITIF DE FABRICATION ADDITIVE D'UN OBJET TRIDIMENSIONNEL

(30) Priorität: 23.12.2015 DE 102015226722
(43) Veröffentlichungstag der Anmeldung: 19.09.2018
(73) Patentinhaber: EOS GmbH Electro Optical Systems, 82152 Krailling (DE)
(72) Erfinder: PHILIPPI, Jochen, 82166 Gräfelfing (DE)
(74) Vertreter: Prüfer & Partner mbB Patentanwälte · Rechtsanwälte
(86) Internationale Anmeldenummer: PCT/EP2016/081884
(87) Internationale Veröffentlichungsnummer: WO 2017/108762

(56) Entgegenhaltungen:
- WO-A1-99/10136
- WO-A2-2010/115588
- US-A1- 2014 027 421

## Beschreibung

Die vorliegende Erfindung bezieht sich auf ein eine Vorrichtung und ein Verfahren zum Kalibrieren einer Vorrichtung zum generativen Herstellen eines dreidimensionalen Objekts insbesondere durch schichtweises Aufbringen und selektives Verfestigen eines Aufbaumaterials mittels Strahlung.

Vorrichtungen dieser Art werden beispielsweise beim Rapid Prototyping, Rapid Tooling oder Additive Manufacturing verwendet. Ein Beispiel eines solchen Verfahrens ist unter dem Namen "Selektives Lasersintern oder Laserschmelzen" bekannt. Dabei wird wiederholt eine dünne Schicht eines pulverförmigen Aufbaumaterials aufgebracht und das Aufbaumaterial in jeder Schicht durch selektives Bestrahlen mit einem Laserstrahl selektiv verfestigt.

Damit die Stellen, an denen der Laserstrahl auf die Pulverschicht auftrifft (Istpositionen), mit den gewünschten Stellen (Sollpositionen) übereinstimmen, muss die Vorrichtung im Voraus kalibriert werden.

DE 199 18 613 A1 beschreibt ein Verfahren zum Kalibrieren einer Vorrichtung zum generativen Herstellen eines dreidimensionalen Objekts, bei dem eine Kalibrierplatte mit Referenzmarkierungen und einem gegenüber der Strahlung der Vorrichtung empfindlichen Medium an einer bekannten Stelle in der Vorrichtung angeordnet wird und durch Belichten des Medium mit der Strahlung der Vorrichtung ein Testbild erzeugt. Dieses Testbild wird digitalisiert, und durch Vergleich des Testbilds mit den Referenzmarkierungen werden Korrekturdaten zur Steuerung der Bestrahlungseinrichtung der Vorrichtung berechnet.

DE 20 2009 016 585 A1 beschreibt ein Verfahren zum Kalibrieren einer Vorrichtung zum generativen Herstellen eines dreidimensionalen Objekts-, bei dem eine Bildwandlerplatte in einer Arbeitsebene der Vorrichtung angeordnet und durch einen Laserstrahl abgetastet wird. Die Bildwandlerplatte ist aus einem Material gebildet, das bei Bestrahlen mit dem Laserstrahl detektierbares Licht abgibt. Oberhalb der Bildwandlerplatte ist eine Lochmaske angeordnet, in der an vorbestimmten Stellen Löcher gebildet sind. Diese Löcher sind vorzugsweise in Form einer Matrix über die gesamte Lochmaske verteilt. Trifft der Laserstrahl eines der Löcher, erzeugt die Bildwandlerplatte detektierbares Licht, das durch einen unter der Bildwandlerplatte angebrachten Detektor erfasst wird. Beim Erfassen des Lichts werden die Koordinaten, zu denen die Bestrahlvorrichtung den Laserstrahl aussendet, mit den bekannten Koordinaten der Löcher verglichen und daraus Korrekturdaten abgeleitet.

DE 10 2013 208 651 A1 beschreibt ein Verfahren zum Kalibrieren einer Vorrichtung zum generativen Herstellen eines dreidimensionalen Objekts, bei dem zwei Bestrahlvorrichtungen verwendet werden. In dem Überlappungsbereich beider Bestrahlvorrichtungen wird von jeder Bestrahlvorrichtung ein Testmuster in einem lichtempfindlichen Medium oder einer aufgebrachten Pulverschicht erzeugt. Die beiden Testmuster werden miteinander oder mit einem Referenzmuster verglichen und die beiden Bestrahlvorrichtungen so kalibriert, dass die Abweichungen unterhalb einer vorgegebenen Schwelle liegen.

US 2014/027421 A1 zeigt eine Vorrichtung und ein Verfahren zum Ermitteln eines Fokuspunkts oder eines Strahlprofils eines Laserstrahls. Hierzu ist in einem Arbeitsbereich eine Lochblende mit einer oder mehreren Öffnung(en) vorgesehen, durch die das Laserlicht auf einen hinter der Öffnung angeordneten Detektor trifft. Der Laserstrahl wird auf verschiedene Messpunkte gerichtet und jeweils die auf den Detektor auftreffende Laserleistung gemessen.

WO 2010/115588 A zeigt eine Vorrichtung und ein Verfahren zum Kalibrieren einer Bestrahlungsvorrichtung einer additiven Herstellvorrichtung. Hierzu ist eine Bildwandlerplatte vorgesehen, die detektierbares Licht abgibt, wenn die Strahlung der Bestrahlungsvorrichtung durch Löcher einer Lochplatte auf die Bildwandlerplatte trifft. Das detektierbare Licht wird von einem Lichtdetektor erfasst.

WO 99/10136 A1 zeigt eine Vorrichtung und ein Verfahren zum Kalibrieren eines Systems. Die Kalibriervorrichtung umfasst einen Laser, der einen Laserstrahl erzeugt, welcher durch ein Loch einer Lochplatte auf eine Erfassungseinrichtung trifft. Bei dem Kalibrierverfahren wird der Laserstrahl auf eine Mehrzahl von Kalibrierpositionen gerichtet, wobei zwischen Kalibrierpositionen, bei denen der Laserstrahl durch das Loch auf den Detektor trifft und solchen, die außerhalb des Loches liegen und für die der Detektor kein Signal erfasst, unterschieden wird. Aus diesen Informationen wird ein Korrekturfaktor für das zu kalibrierende System ermittelt.

Die Aufgabe der vorliegenden Erfindung besteht darin, eine alternative, vorzugsweise verbesserte Vorrichtung bzw. ein alternatives, vorzugsweise verbessertes Verfahren zum Kalibrieren einer Vorrichtung zum generativen Herstellen eines dreidimensionalen Objekts insbesondere durch schichtweises Aufbringen und selektives Verfestigen eines Aufbaumaterials mittels Strahlung, bereitzustellen.

Die Aufgabe wird gelöst durch eine Kalibriervorrichtung gemäß Anspruch 1, eine Herstellvorrichtung gemäß Anspruch 9, ein Kalibrierverfahren gemäß Anspruch 11 und ein Herstellverfahren gemäß Anspruch 14. Weiterbildungen der Erfindung sind jeweils in den Unteransprüchen angegeben. Dabei können die Verfahren auch durch die untenstehenden bzw. in den Unteransprüchen ausgeführten Merkmale der Vorrichtungen weitergebildet sein oder umgekehrt bzw. die Merkmale der Verfahren und/oder der Vorrichtungen können auch jeweils untereinander zur Weiterbildung genutzt werden.

Die erfindungsgemäße Kalibrierleiste dient zum Kalibrieren einer Herstellvorrichtung zum Herstellen eines dreidimensionalen Objekts innerhalb eines Baufelds durch schichtweises Verfestigen eines Aufbaumaterials an den dem jeweiligen Querschnitt des Objekts entsprechenden Stellen durch selektives Bestrahlen von Schichten des Aufbaumaterials mit einer Strahlung in einer Arbeitsebene. Die Herstellvorrichtung weist eine Bestrahlungsvorrichtung auf, die in der Lage ist, selektiv eine zur Verfestigung des Aufbaumaterials geeignete Strahlung, vorzugsweise Laserstrahlung, in weiter bevorzugter Weise Strahlung eines Gaslasers, speziell eines Gaslasers im niederen bis mittleren Wellenlängenbereich, speziell bevorzugt eines Gaslasers, auf verschiedene Stellen der Arbeitsebene innerhalb des Baufelds zu richten. Die Kalibrierleiste weist eine längliche Form auf und enthält eine sich in ihrer Längsrichtung erstreckende Blendenleiste, die eine Mehrzahl von in der Längsrichtung der Kalibrierleiste in einer Reihe angeordneten Blendenöffnungen aufweist, welche für die Strahlung der Bestrahlungsvorrichtung stärker durchlässig sind als der die Blendenöffnungen umgebende Bereich der Blendenleiste. Die Kalibrierleiste enthält ferner eine sich in ihrer Längsrichtung erstreckende, im Wesentlichen parallel zu der Blendenleiste angeordnete Sensorleiste, die zumindest einen Flächensensor enthält, der in der Lage ist, die Strahlung der Bestrahlungsvorrichtung zu detektieren. Die Kalibrierleiste ist so in der Herstellvorrichtung anbringbar, dass die Strahlung der Bestrahlungsvorrichtung durch die Blendenöffnungen auf den zumindest einen Flächensensor auftreffen kann, wobei die Kalibrierleiste vorzugsweise so in der Herstellvorrichtung anbringbar ist, dass die Blendenleiste in der Arbeitsebene der Herstellvorrichtung liegt. Mit einer solchen Kalibrierleiste ist es beispielsweise möglich, die Bestrahlungsvorrichtung der Herstellvorrichtung so zu kalibrieren, dass die ausgesendete Strahlung genau an dem gewünschten Zielort auf das Baufeld auftrifft.

Vorzugsweise sind die Blendenöffnungen für die Strahlung der Bestrahlungsvorrichtung zumindest 10-mal, vorzugsweise 100-mal, in weiter bevorzugter Weise zumindest 1000-mal stärker durchlässig als der die Blendenöffnungen umgebende Bereich der Blendenleiste. Dadurch kann beispielsweise ein hinreichender Kontrast in einem Ausgangssignal des Flächensensors erzielt werden, der es ermöglicht, zu unterscheiden, wann die Strahlung durch die Blendenöffnung hindurchtritt und wann nicht.

Vorzugsweise sind die Blendenöffnungen in der Richtung zu der Sensorleiste hin verbreitert und/oder haben einen Durchmesser, der im Bereich von einem Zehntel bis zum Zehnfachen des Fokusdurchmessers der Strahlung der Bestrahlungsvorrichtung liegt. Dadurch kann beispielsweise die Herstellung der Blendenöffnung vereinfacht und/oder ihr Durchmesser flexibel an die Bedürfnisse angepasst werden.

Vorzugsweise weist die Sensorleiste eine Mehrzahl von Flächensensoren auf, die in der Längsrichtung der Kalibrierleiste hintereinander angeordnet sind. Das kann beispielsweise wirtschaftlicher sein als das Verwenden eines einzigen, sich über die gesamte Länge erstreckenden Flächensensors.

Vorzugsweise weist der zumindest eine Flächensensor oder zumindest einer aus der Mehrzahl von Flächensensoren, bevorzugt jeder aus der Mehrzahl von Flächensensoren, eine Ausdehnung in der Längsrichtung der Kalibrierleiste auf, die größer ist als der Abstand zwischen zwei benachbarten Blendenöffnungen. Dadurch kann die Anzahl verwendeter Flächensensoren verringert werden.

Vorzugsweise ist der zumindest eine Flächensensor oder zumindest einer aus der Mehrzahl von Flächensensoren ein ortsauflösender Sensor. Dadurch kann beispielsweise direkt der Ort eines Maximums der Intensität der einfallenden Strahlung bestimmt werden.

Die erfindungsgemäße Kalibriervorrichtung dient zum Kalibrieren einer Herstellvorrichtung zum Herstellen eines dreidimensionalen Objekts durch schichtweises Verfestigen eines Aufbaumaterials an den dem jeweiligen Querschnitt des Objekts entsprechenden Stellen durch selektives Bestrahlen von Schichten des Aufbaumaterials mit einer Strahlung in einer Arbeitsebene der Herstellvorrichtung. Die Kalibriervorrichtung enthält eine Kalibrierleiste der oben beschriebenen Art und zumindest eine Auswerteeinheit, die geeignet ist, ein Ausgangssignals des zumindest einen Flächensensors auszuwerten. Die zumindest eine Auswerteeinheit ist geeignet, Amplituden und/oder Längen von in dem Ausgangssignal enthaltenen Einzelpulsen zu ermitteln, eine örtliche Verteilung der ermittelten Amplituden und/oder Längen aufzustellen und diese örtliche Verteilung auszuwerten. Durch eine solche Kalibriervorrichtung können beispielsweise die gewünschten Daten aus einem Ausgangssignal des Flächensensors gewonnen werden.

Vorzugsweise weist die Kalibrierleiste eine Mehrzahl von Flächensensoren auf, und zumindest eine Auswerteeinheit ist mit mehr als einem Flächensensoren der Kalibrierleiste verbunden. In weiter bevorzugter Weise sind die mit derselben Auswerteeinheit verbundenen Flächensensoren elektrisch in Reihe geschaltet. Dadurch kann beispielsweise die Anzahl der erforderlichen Auswerteeinheiten verringert werden.

Vorzugsweise weist die Kalibrierleiste eine Mehrzahl von Flächensensoren auf, und die Kalibriervorrichtung enthält für jeden aus der Mehrzahl von Flächensensoren eine eigene Auswerteeinheit. Dadurch können beispielsweise mehrere Blendenöffnungen, die verschiedenen Flächensensoren zugeordnet sind, gleichzeitig vermessen werden.

Die erfindungsgemäße Herstellvorrichtung dient zum Herstellen eines dreidimensionalen Objekts durch schichtweises Verfestigen eines Aufbaumaterials innerhalb eines Baufelds an den dem jeweiligen Querschnitt des Objekts entsprechenden Stellen durch selektives Bestrahlen von Schichten des Aufbaumaterials mit einer Strahlung in einer Arbeitsebene. Die Herstellvorrichtung enthält eine Bestrahlungsvorrichtung, die in der Lage ist, selektiv eine zur Verfestigung des Aufbaumaterials geeignete Strahlung, vorzugsweise Laserstrahlung, in weiter bevorzugter Weise Strahlung eines Gaslasers, auf verschiedene Stellen der Arbeitsebene innerhalb des Baufelds zu richten, und eine Kalibrierleiste und/oder eine Kalibriervorrichtung der oben beschriebenen Art. Die Kalibrierleiste ist so in der Herstellvorrichtung angeordnet, dass die Strahlung der Bestrahlungsvorrichtung durch die Blendenöffnungen auf den zumindest einen Flächensensor auftreffen kann, und vorzugsweise so, dass die Blendenleiste in der Arbeitsebene der Herstellvorrichtung liegt. Vorzugsweise ist die Kalibrierleiste bewegbar in der Herstellvorrichtung angeordnet, in weiter bevorzugter Weise quer zu ihrer Längsrichtung bewegbar und in noch weiter bevorzugter Weise senkrecht zu ihrer Längsrichtung bewegbar. Mit einer solchen Herstellvorrichtung ist es beispielsweise möglich, die Bestrahlungsvorrichtung der Herstellvorrichtung so zu kalibrieren, dass die ausgesendete Strahlung genau an dem gewünschten Zielort auf das Baufeld auftrifft.

Vorzugsweise enthält die erfindungsgemäße Herstellvorrichtung weiter einen sich in einer Bewegungsrichtung über das Baufeld bewegbaren Beschichter zum Aufbringen einer Schicht des Aufbaumaterials auf das Baufeld, und die Kalibrierleiste ist an dem Beschichter und mit diesem gemeinsam bewegbar so angebracht, dass ihre Längsrichtung sich quer, vorzugsweise senkrecht zu der Bewegungsrichtung des Beschichters erstreckt. Dadurch kann beispielsweise ein bereits in der Vorrichtung vorhandener Antrieb, nämlich der Antrieb des Beschichters, zum Verfahren der Kalibrierleiste über das Baufeld verwendet werden.

Das erfindungsgemäße Kalibrierverfahren dient zum Kalibrieren einer Herstellvorrichtung zum Herstellen eines dreidimensionalen Objekts innerhalb eines Baufelds durch schichtweises Verfestigen eines Aufbaumaterials an den dem jeweiligen Querschnitt des Objekts entsprechenden Stellen durch selektives Bestrahlen von Schichten des Aufbaumaterials mit einer Strahlung in einer Arbeitsebene. Die Herstellvorrichtung weist eine Bestrahlungsvorrichtung auf, die in der Lage ist, selektiv eine zur Verfestigung des Aufbaumaterials geeignete Strahlung, vorzugsweise Laserstrahlung, in weiter bevorzugter Weise Strahlung eines Gaslasers, auf verschiedene Stellen der Arbeitsebene innerhalb des Baufelds zu richten. Das Verfahren weist die folgenden Schritte auf: Anbringen einer Kalibrierleiste der oben beschriebenen Art innerhalb der Herstellvorrichtung dergestalt, dass die Strahlung der Bestrahlungsvorrichtung durch die Blendenöffnungen auf den zumindest einen Flächensensor auftreffen kann, und vorzugsweise so, dass die Blendenleiste (42) in der Arbeitsebene der Herstellvorrichtung liegt, Abtasten zumindest einer Blendenöffnung der Kalibrierleiste durch die Strahlung der Bestrahlungsvorrichtung, Erfassen eines Ausgangssignals des zumindest einen Flächensensors, Ermitteln der Position des Mittelpunkts der zumindest einen Blendenöffnung in einem Bestrahlungskoordinatensystem aus dem erfassten Ausgangssignal, Vergleichen der Position des Mittelpunkts der zumindest einen Blendenöffnung in dem Bestrahlungskoordinatensystem mit einer bekannten Position des Mittelpunkts der Blendenöffnung in einem fest mit dem Baufeld verbundenen Maschinenkoordinatensystem und Berechnen von Korrekturdaten für die Bestrahlungsvorrichtung aus dem Ergebnis des Vergleichs. Vorzugsweise werden zwei oder mehr Blendenöffnungen der Kalibrierleiste von der Strahlung der Bestrahlungsvorrichtung abgetastet und ihre Positionen in dem Bestrahlungskoordinatensystem ermittelt und/oder die Kalibrierleiste wird quer zu ihrer Längsrichtung, in bevorzugter Weise senkrecht zu ihrer Längsrichtung über das Baufeld bewegt und in zumindest einer weiteren Position der Kalibrierleiste zumindest eine Blendenöffnung von der Strahlung der Bestrahlungsvorrichtung abgetastet und ihre Position in dem Bestrahlungskoordinatensystem ermittelt wird. Mit einem solchen Kalibrierverfahren ist es beispielsweise möglich, die Bestrahlungsvorrichtung der Herstellvorrichtung so zu kalibrieren, dass die ausgesendete Strahlung genau an dem gewünschten Zielort auf das Baufeld auftrifft.

Vorzugsweise enthält der Schritt des Abtastens zumindest einer Blendenöffnung einen ersten Schritt des Abtastens der Blendenöffnung durch die Strahlung der Bestrahlungsvorrichtung in Form von Vektoren, die parallel zueinander in eine erste Richtung oder deren Gegenrichtung verlaufen und voneinander beabstandet sind, und einen zweiten Schritt des Abtastens der Blendenöffnung durch die Strahlung der Bestrahlungsvorrichtung in Form von Vektoren, die parallel zueinander in eine zweite Richtung oder deren Gegenrichtung verlaufen und voneinander beabstandet sind, wobei die zweite Richtung quer, vorzugsweise senkrecht zu der ersten Richtung ist. Vorzugsweise enthält weiter der Schritt des Erfassen eines Ausgangssignals des zumindest einen Flächensensors für jeden der beiden Abtastschritte das Ermitteln von Amplituden und/oder Längen einzelner Pulse, die den Vektoren entsprechen. Vorzugsweise enthält weiter der Schritt des Ermittelns des Mittelpunkts der Blendenöffnung in dem Bestrahlungskoordinatensystem für jeden der beiden Abtastschritte das Aufstellen einer örtlichen Verteilung der ermittelten Amplituden und/oder Längen und das Auswerten dieser örtlichen Verteilung. Dadurch kann beispielsweise die Kalibrierung unempfindlicher gegen Zeitverzögerungen und/oder andere Zeitfaktoren gemacht werden.

Vorzugsweise enthält das Kalibrierverfahren zusätzlich nach dem Kalibrieren der Bestrahlungsvorrichtung das Messen eines Fokusdurchmessers einer von der Bestrahlungsvorrichtung abgegebenen Strahlung mit den Schritten: Abtasten einer Blendenöffnung der Kalibrierleiste durch die Strahlung der Bestrahlungsvorrichtung in Form eines Abtastvektors, der durch den Blendenmittelpunkt geht, mit einer vorbestimmten Abtastgeschwindigkeit, Messen einer Zeitdauer eines Pulses des Ausgangssignals des Flächensensors, Berechnen des Fokusdurchmessers der Strahlung aus der gemessenen Zeitdauer und der vorbestimmten Abtastgeschwindigkeit. Dadurch kann beispielsweise eine Kontrolle des Strahlprofils der von der Bestrahlungsvorrichtung abgegebenen Strahlung in der Beobachtungseben erfolgen.

Das erfindungsgemäße Herstellverfahren dient zum Herstellen eines dreidimensionalen Objekts innerhalb eines Baufelds und enthält die Schritte: Auftragen einer Schicht eines Aufbaumaterials mit einem Beschichter durch Bewegen des Beschichters über das Baufeld, Verfestigen der Schicht des Aufbaumaterials an den dem jeweiligen Querschnitt des Objekts entsprechenden Stellen durch selektives Bestrahlen mit einer zur Verfestigung des Aufbaumaterials geeigneten Strahlung, vorzugsweise Laserstrahlung, in weiter bevorzugter Weise Strahlung eines Gaslasers, innerhalb des Baufelds, und Wiederholen der Schritte des Auftragens und des Verfestigens, bis das dreidimensionale Objekt fertiggestellt ist. Dabei wird zumindest einmal vor dem Herstellverfahren oder während des Herstellverfahrens ein Kalibrierverfahren der oben beschriebenen Art durchgeführt wird. Dadurch kann beispielsweise ein Objekt mit höherer Genauigkeit hergestellt werden als ohne Kalibrierung.
- Fig. 1: ist eine schematische, teilweise im Schnitt dargestellte Ansicht einer Vorrichtung zum schichtweisen generativen Herstellen eines dreidimensionalen Objekts gemäß einer Ausführungsform der vorliegenden Erfindung.
- Fig. 2a: ist eine schematische perspektivische Ansicht einer in der Vorrichtung aus Fig. 1 an einem Beschichter angebrachten Kalibrierleiste.
- Fig. 2b: ist eine schematische Schnittansicht der Kalibrierleiste.
- Fig. 2c: ist eine schematische Draufsicht auf die Kalibrierleiste.
- Fig. 3a: ist eine schematische Draufsicht zum Erläutern des Abtastens einer Blendenöffnung mit dem Laserstrahl in Form einzelner Vektoren.
- Fig. 3b und 3c: sind Diagramme, die ein Ausgangssignal eines Sensors der Kalibrierleiste für einen Einzelvektor zeigen.
- Fig. 4a: ist ein Diagramm, das eine perspektivische 3D-Darstellung der gemessenen Lichtintensitäten zeigt.
- Fig. 4b: ist ein Diagramm, das übereinandergelegt Zeitverläufe der gemessenen Lichtintensitäten zeigt.
- Fig. 4c: ist ein Diagramm, das eine örtliche Verteilung von Amplituden von gemessenen Lichtintensitätsverläufe zeigt.
- Fig. 4d: ist ein Diagramm, das eine Einhüllende der in Fig. 4c gezeigten Amplituden zeigt.

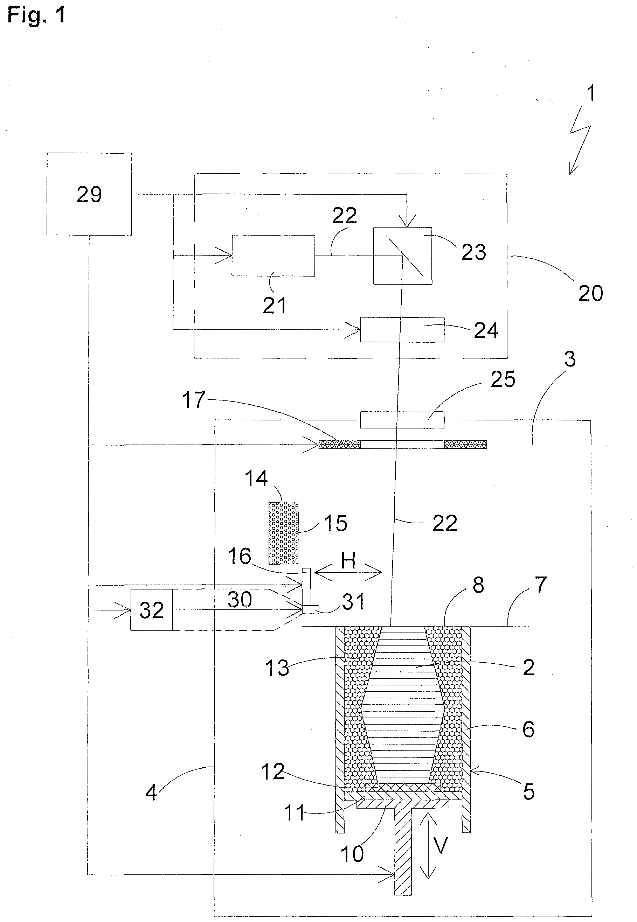

Im Folgenden wird mit Bezug auf Fig. 1 eine Vorrichtung zum schichtweisen generativen Herstellen eines dreidimensionalen Objekts gemäß einer Ausführungsform der vorliegenden Erfindung beschrieben. Die in Fig. 1 dargestellte Vorrichtung ist eine Lasersinter- oder Laserschmelzvorrichtung 1. Zum Aufbauen eines Objekts 2 enthält sie eine Prozesskammer 3 mit einer Kammerwandung 4.

In der Prozesskammer 3 ist ein nach oben offener Behälter 5 mit einer Wandung 6 angeordnet. Durch die obere Öffnung des Behälters 5 ist eine Arbeitsebene 7 definiert, wobei der innerhalb der Öffnung liegende Bereich der Arbeitsebene 7, der zum Aufbau des Objekts 2 verwendet werden kann, als Baufeld 8 bezeichnet wird.

In dem Behälter 5 ist ein in einer vertikalen Richtung V bewegbarer Träger 10 angeordnet, an dem eine Grundplatte 11 angebracht ist, die den Behälter 5 nach unten abschließt und damit dessen Boden bildet. Die Grundplatte 11 kann eine getrennt von dem Träger 10 gebildete Platte sein, die an dem Träger 10 befestigt ist, oder sie kann integral mit dem Träger 10 gebildet sein. Je nach verwendetem Pulver und Prozess kann auf der Grundplatte 11 noch eine Bauplattform 12 angebracht sein, auf der das Objekt 2 aufgebaut wird. Das Objekt 2 kann aber auch auf der Grundplatte 11 selber aufgebaut werden, die dann als Bauplattform dient. In Fig. 1 ist das in dem Behälter 5 auf der Bauplattform 12 zu bildende Objekt 2 unterhalb der Arbeitsebene 7 in einem Zwischenzustand dargestellt mit mehreren verfestigten Schichten, umgeben von unverfestigt gebliebenem Aufbaumaterial 13.

Die Lasersintervorrichtung 1 enthält weiter einen Vorratsbehälter 14 für ein durch elektromagnetische Strahlung verfestigbares pulverförmiges Aufbaumaterial 15 und einen in einer horizontalen Richtung H bewegbaren Beschichter 16 zum Aufbringen des Aufbaumaterials 15 auf das Baufeld 8.

Die Lasersintervorrichtung 1 enthält ferner eine Belichtungsvorrichtung 20 mit einem Laser 21, vorzugsweise einem Gaslaser wie z.B. einem CO₂-Laser, der einen Laserstrahl 22 erzeugt, der über eine Umlenkvorrichtung 23 umgelenkt und durch eine Fokussiervorrichtung 24 über ein Einkoppelfenster 25, das an der Oberseite der Prozesskammer 3 in deren Wandung 4 angebracht ist, auf die Arbeitsebene 7 fokussiert wird.

Weiter enthält die Lasersintervorrichtung 1 eine Steuereinheit 29, über die die einzelnen Bestandteile der Vorrichtung 1 in koordinierter Weise zum Durchführen des Bauprozesses gesteuert werden. Die Steuereinheit kann eine CPU enthalten, deren Betrieb durch ein Computerprogramm (Software) gesteuert wird. Das Computerprogramm kann getrennt von der Vorrichtung auf einem Speichermedium gespeichert sein, von dem aus es in die Vorrichtung, insbesondere in die Steuereinheit geladen werden kann.

Im Betrieb wird zum Aufbringen einer Pulverschicht zunächst der Träger 10 um eine Höhe abgesenkt, die der gewünschten Schichtdicke entspricht. Durch Verfahren des Beschichters 16 über die Arbeitsebene 7 wird dann eine Schicht des pulverförmigen Aufbaumaterials 15 aufgebracht. Das Aufbringen erfolgt zumindest über den gesamten Querschnitt des herzustellenden Objekts 2, vorzugsweise über das gesamte Baufeld 8, also den Bereich der Arbeitsebene 7, der durch eine Vertikalbewegung des Trägers abgesenkt werden kann. Anschließend wird der Querschnitt des herzustellenden Objekts 2 von dem Laserstrahl 22 abgetastet, so dass das pulverförmige Aufbaumaterial 15 an den Stellen verfestigt wird, die dem Querschnitt des herzustellenden Objekts 2 entsprechen. Diese Schritte werden solange wiederholt, bis das Objekt 2 fertiggestellt ist und der Prozesskammer 3 entnommen werden kann.

Zum Kalibrieren der Belichtungsvorrichtung 20 enthält die Lasersintervorrichtung 1 eine Kalibriervorrichtung 30, die eine Kalibrierleiste 31 und eine Auswerteeinheit 32 umfasst. Die Kalibrierleiste 31 ist in der Prozesskammer 3 angeordnet und an dem Beschichter 16 mit diesem gemeinsam verfahrbar befestigt. Die Auswerteeinheit 32 ist vorzugsweise außerhalb der Prozesskammer 3 angeordnet und mit der Kalibrierleiste 31 signaltechnisch verbunden. Die Auswerteeinheit 32 kann auch in der Steuereinheit 29 integriert sein, statt als getrennte Einheit ausgebildet zu sein, oder sie kann in der Kalibrierleiste 31 integriert sein.

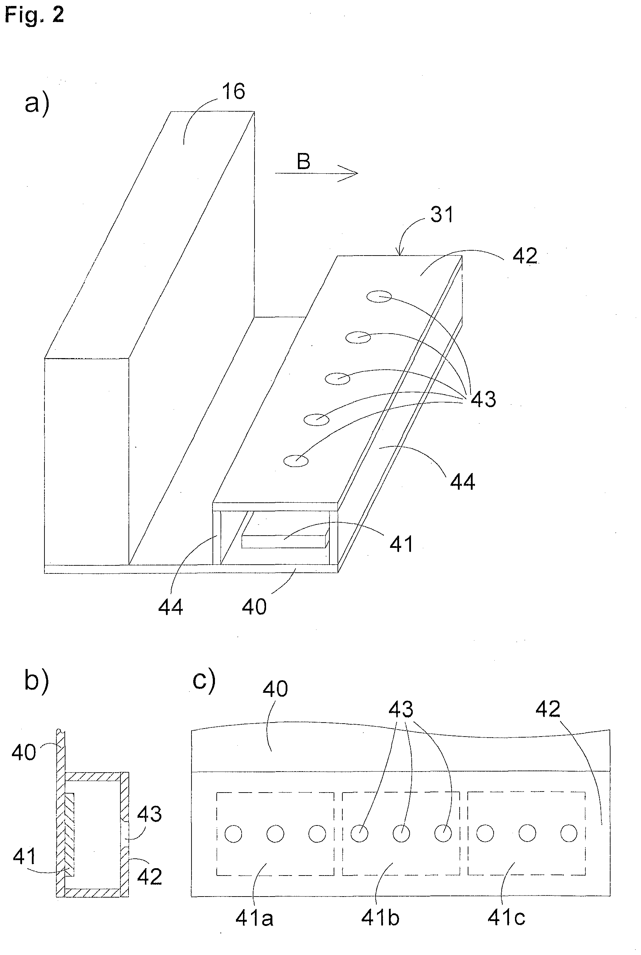

Fig. 2a ist eine schematische, nicht maßstäbliche perspektivische Ansicht des Beschichters 16 mit der daran angebrachten Kalibrierleiste 31.

Der Beschichter 16 ist in der Figur stellvertretend für jede in Lasersinteranlagen anwendbare Beschichterform rein schematisch als Quader dargestellt, der sich in eine Längsrichtung erstreckt und in eine Bewegungsrichtung B quer zu seiner Längsrichtung, vorzugsweise senkrecht zu seiner Längsrichtung, bewegbar ist. An dem Beschichter 16 ist die Kalibrierleiste 31 angebracht, die ebenfalls eine längliche Form hat. Länglich bedeutet dabei, dass die Abmessung in einer ersten Richtung deutlich größer ist als in einer zweiten Richtung quer zur ersten Richtung, vorzugsweise mindestens doppelt so groß, in weiter bevorzugter Weise mindestens fünf Mal so groß und in noch weiter bevorzugter Weise mindestens zehn Mal so groß. Die Anbringung erfolgt vorzugsweise so, dass sich die Längsrichtung der Kalibrierleiste 31 parallel zu der Längsrichtung des Beschichters 16 erstreckt. Die Kalibrierleiste 31 als Ganze oder zumindest Teile von ihr sind von dem Beschichter 16 bevorzugt lösbar.

Die Kalibrierleiste 31 enthält eine sich in der Längsrichtung der Kalibrierleiste 31 erstreckende Sensorleiste 40, über die die Kalibrierleiste 31 an dem Beschichter 16 angebracht ist. Auf der Sensorleiste 40 ist ein sich ebenfalls in der Längsrichtung der Kalibrierleiste 31 erstreckender Flächensensor 41 angebracht, der in der Lage ist, die in der Vorrichtung 1 verwendete Laserstrahlung zu detektieren.

Weiter enthält die Kalibrierleiste 31 parallel zu der Sensorleiste 40 auf der Seite des Flächensensors 41 eine sich ebenfalls in der Längsrichtung der Kalibrierleiste 31 erstreckende Blendenleiste 42 aus einem lichtundurchlässigen Material, beispielsweise eine Metallleiste. In der Blendenleiste 42 ist eine Mehrzahl von Blendenöffnungen 43 in der Längsrichtung der Kalibrierleiste 31 in einer Reihe angeordnet. Die Blendenöffnungen 43 sind als Durchgangsbohrungen in der Blendenleiste 42 gebildet. Die Anordnung in einer Reihe ist nicht auf die in Fig. 2a gezeigte Anordnung auf einer Gerade beschränkt. Die Blendenöffnungen 43 können beispielsweise auch in Form einer Schlangenlinie, einer Stufenlinie, einer Zickzacklinie usw. angeordnet sein. Der Flächensensor 41 ist dabei zumindest so groß, dass bei senkrechtem Lichteinfall auf die Blendenleiste 43 das durch alle Blendenöffnungen 43 hindurchtretende Licht auf ihn auftrifft.

Der Zwischenraum zwischen der Sensorleiste 40 und der Blendenleiste 42 ist durch Seitenwände 44 abgeschlossen. Während in Fig. 2a Seitenwände 44 der Übersichtlichkeit halber nur auf den Längsseiten gezeigt sind, können sie auch auf den Schmalseiten angeordnet sein. Die Seitenwände 44 können auch einstückig mit der Blendenleiste 42 gebildet sein, die dann ein U-Profil aufweist, oder mit der Sensorleiste 40.

Die Kalibrierleiste 31 ist so an dem Beschichter 16 angebracht, dass die Blendenleiste 42 oberhalb der Sensorleiste 40 liegt, so dass die Strahlung der Bestrahlungsvorrichtung 20 auf direktem Weg, d.h. ohne Reflexion und/oder Streuung, durch die Blendenöffnungen 43 auf den Flächensensor 41 auftreffen kann.

Fig. 2b ist eine schematische Schnittansicht durch die Kalibrierleiste 31 (gegenüber Fig. 2a verdreht um 90°). Wie aus dieser Schnittansicht ersichtlich haben die Durchgangsbohrungen, die die Blendenöffnungen 43 bilden, keinen konstanten Querschnitt, sondern sind in der Richtung zu der Sensorleiste hin verbreitert. In der vorliegenden Ausführungsform verläuft zunächst eine Bohrung mit konstantem Querschnitt in der Richtung zu der Sensorleiste hin und verbreitet sich dann linear, die Bohrung ist also auf der Seite der Sensorleiste abgefast. Diese Abfasung erleichtert das Bohren eines dünnen Durchgangslochs auch bei einer dicken Blendenleiste. Die Verbreiterung kann aber auch über die gesamte Länge der Bohrung hin erfolgen. Sie muss auch nicht linear sein, sondern kann beispielsweise auch treppenförmig oder gekrümmt verlaufen.

Fig. 2c ist eine schematische Draufsicht auf die Kalibrierleiste 31. Anstelle eines durchgehenden Flächensensors 41 sind in diesem Beispiel drei Flächensensoren 41a, 41b, 41c (als verdeckte Elemente durch eine gestrichelte Linie gekennzeichnet) getrennt voneinander bereitgestellt und in der Längsrichtung der Kalibrierleiste 31 hintereinander angeordnet. Dabei ist jeder der drei Flächensensoren in der Längsrichtung der Kalibrierleiste 31 länger als ein Abstand zwischen benachbarten Blendenöffnungen 43. Im Extremfall kann auch für jede der Blendenöffnungen 43 ein eigener Flächensensor bereitgestellt sein.

Für die Kalibrierung ist es von untergeordneter Bedeutung, wie viele Flächensensoren bereitgestellt sind. In der Praxis wird man eher mehrere Flächensensoren verwenden, weil ein großer, sich über die gesamte Länge der Kalibrierleiste erstreckender Flächensensor nicht wirtschaftlich zu fertigen ist.

Als Flächensensor können alle Sensortypen verwendet werden, die in der Lage sind, die zum Verfestigen des Aufbaumaterials verwendete Strahlung zu detektieren. Bei einem CO₂-Laser wird vorzugsweise ein thermalelektrischer Atomlagensensor verwendet. Der Sensor gibt ein der gemessenen Intensität des Laserstrahls entsprechendes Ausgangssignal an die Auswerteeinrichtung aus. Dieses Signal kann beispielsweise proportional zu der gemessenen Intensität sein oder logarithmisch verlaufen oder über eine andere Funktion von der Intensität abhängen.

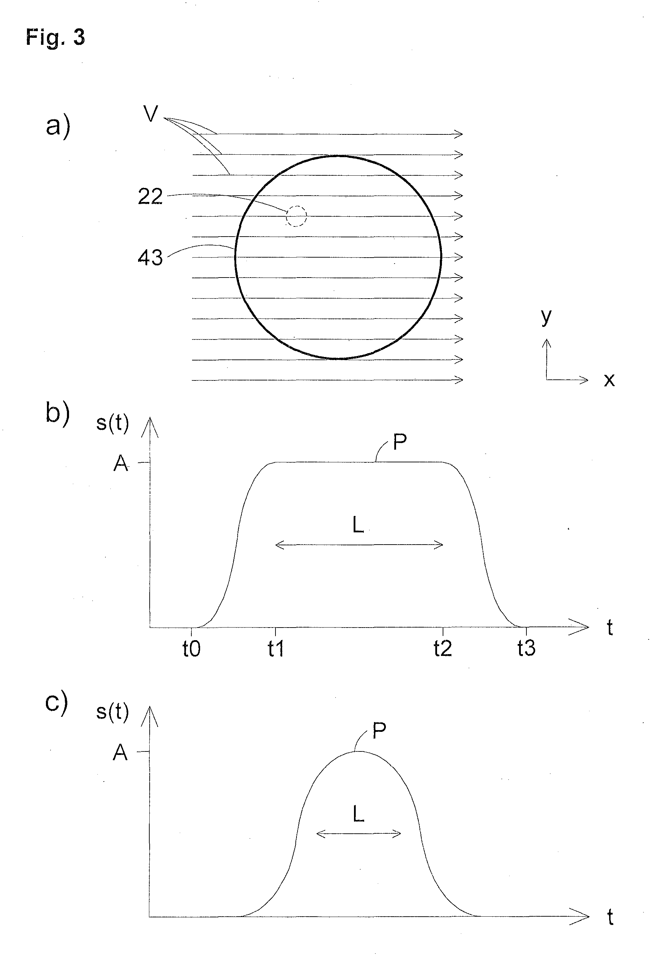

Zum Kalibrieren der Vorrichtung wird der Beschichter 16 so verfahren, dass die Blendenleiste 42 in der Arbeitsebene 7 (d.h. in der Fokusebene des Laserstrahls 22) liegt und die Blendenöffnungen 43 sich an vorbestimmten Positionen des Baufeldes 8 befinden. Anschließend wird zumindest eine, vorzugweise mehrere der Blendenöffnungen 43 durch den Laserstrahl abgetastet. Diese Abtastung wird im Folgenden mit Bezug auf Fig. 3 erläutert.

Wie schematisch in Fig. 3a dargestellt, die eine Draufsicht auf eine in der Arbeitsebene 7 angeordnete Blendenöffnung 43 und ihre Umgebung darstellt, verfährt der Laserstrahl 22, der einen bestimmten Fokusdurchmesser hat und in der Figur durch einen gestrichelten Kreis dargestellt ist, in einer in der Arbeitsebene liegenden x-Richtung über die Blendenöffnung 43. Auch wenn der Laserstrahl 22 in der Figur als Kreis mit festem Durchmesser dargestellt ist, fällt normalerweise die Lichtintensität nach außen allmählich ab, beispielsweise mit einer gaußschen Verteilung. Als Fokusdurchmesser kann in diesem Fall beispielsweise die Halbwertsbreite der Intensitätsverteilung des Laserstrahlprofils definiert sein.

Anschließend wird der Laserstrahl 22 in einer ebenfalls in der Arbeitsebene liegenden y-Richtung, die senkrecht zur x-Richtung ist, um einen vorbestimmten Abstand versetzt und fährt erneut in der x-Richtung über die Blendenöffnung 43. Dies wird mehrmals wiederholt. Das Abtasten der Blendenöffnung 43 erfolgt also in Form mehrerer Scanvektoren S (im Folgenden kurz Vektoren genannt), die sich in der x-Richtung erstrecken und in der y-Richtung voneinander beanstandet sind.

Eine gängige Ausführung der Umlenkvorrichtung 23 enthält zwei Galvanometerspiegel, die den Laserstrahl 22 in zwei zueinander senkrechten Richtungen ablenken. Um den oben beschriebenen Ablauf zu erzielen, bleibt während des Abtasten der Blendenöffnung 43 durch einen Vektor S der eine Spiegel fest, während der andere Spiegel gedreht wird. Anschließend wird der vorher festgehaltene Spiegel um einen vorbestimmten Betrag gedreht und anschließend wieder festgehalten, während der andere Spiegel zum Abtasten des nächsten Vektors gedreht wird. Die Vektoren können wie in Fig. 3a gezeigt in derselben Richtung abgetastet werden oder auch abwechselnd in entgegengesetzten Richtungen.

Dabei geht die Abtastung über die Grenzen der Blendenöffnung 43 hinaus, aber nur die innerhalb der Blendenöffnung 43 liegenden Abschnitte der Vektoren S werden von dem Flächensensor 41 erfasst und anschließend ausgewertet.

Fig. 3b zeigt schematisch einen Zeitverlauf einer gemessenen Lichtintensität, wenn der Laserstrahl 22 einen Vektor S abtastet.

Sobald der Laserstrahl 22 zum Zeitpunkt t0 den (in Fig. 3a linken) Rand der Blendenöffnung 43 erreicht, beginnt ein der gemessenen Intensität entsprechendes Ausgangssignal s(t) des Flächensensors 41 an zusteigen. Wenn der Laserstrahl 22 zum Zeitpunkt t1 voll durch die Blendenöffnung 43 fällt, erreicht das Ausgangssignal s(t) seinen Maximalwert und bleibt annähernd konstant, bis der Laserstrahl 22 zum Zeitpunkt t2 den (in Fig. 3a rechten) Rand der Blendenöffnung 43 erreicht. Danach fällt das Ausgangssignal s(t) wieder ab, bis der Laserstrahl 22 zum Zeitpunkt t3 gar nicht mehr durch die Blendenöffnung 43 hindurch tritt und das Ausgangssignal s(t) zu Null wird. So erzeugt das Abtasten der Blendenöffnung 43 durch den Laserstrahl 22 einen Einzelpuls P, dessen Länge L (Zeitdauer) durch die Abtastgeschwindigkeit des Laserstrahls 22 und die Sehnenlänge der Blendenöffnung 43 an der abgetasteten Stelle bestimmt ist und dessen Amplitude A durch die Intensität des Laserstrahls 22 und die Empfindlichkeit des Flächensensors 41 bestimmt ist. Der Signalverlauf des Einzelpulses P wird zusätzlich durch das Laserstrahlprofil beeinflusst. Einzelpuls meint in diesem Zusammenhang einen durch das Abtasten der Blendenöffnung 43 mit einem Laserstrahl 22 konstanter Intensität entstehenden Puls in dem Ausgangssignal s(t) des Flächensensors 41 und nicht einen Puls eines eventuell gepulst betriebenen Lasers.

Für alle einzelnen Vektoren S ergibt sich ein ähnlicher Signalverlauf (s(t), nur dass die Amplituden A und/oder die Längen L der den Einzelvektoren S entsprechenden Einzelpulse P voneinander verschieden sind. Messtechnisch erfassen lassen sich die Amplituden A der Einzelpulse P beispielsweise über eine Maximalwertmessung über die Pulsdauer und die Längen L Einzelpulse P beispielsweise durch eine Zeitmessung zwischen zwei Zeitpunkten, in denen das Ausgangssignal s(t) eine vorbestimmte Schwelle überschreitet, z.B. 5%, 50% (=Halbwertsbreite) oder 95% des Maximalwerts, oder durch Integrieren des Signalwerts über die gesamte Dauer eines Pulses P. Dabei kommt es nicht auf den exakten Wert der Bestimmung der Länge L an, sondern auf die relativen Unterschiede zwischen den Längen L der Einzelpulse P.

Fig. 3c zeigt schematisch einen Zeitverlauf einer gemessenen Lichtintensität, wenn der Laserstrahl 22 einen Vektor S abtastet und der Durchmesser bzw. das abgetastete Kreissegment der Blendenöffnung 43 ungefähr gleich dem Fokusdurchmesser des Laserstrahls 22 ist. Der dabei entstehende Signalverlauf s(t) hat keinen Bereich mit annähernd konstantem Signalpegel, sondern einen glockenförmigen Verlauf. Auch hierbei lassen sich messtechnisch eine Amplitude A und eine Länge L, z.B. die Halbwertsbreite der Glockenkurve, ermitteln.

Wenn der Durchmesser der Blendenöffnung 43 wesentlich kleiner als der Fokusdurchmesser des Laserstrahls 22 ist, ergibt sich wieder ein ähnlicher Signalverlauf s(t) wie der in Fig. 3b gezeigte, aber mit einer wesentlich kleineren Amplitude A, weil nie der gesamte Laserstrahl, sondern immer nur ein durch die Blendenöffnung 43 gefilterter Ausschnitt auf den Flächensensor 41 auftrifft.

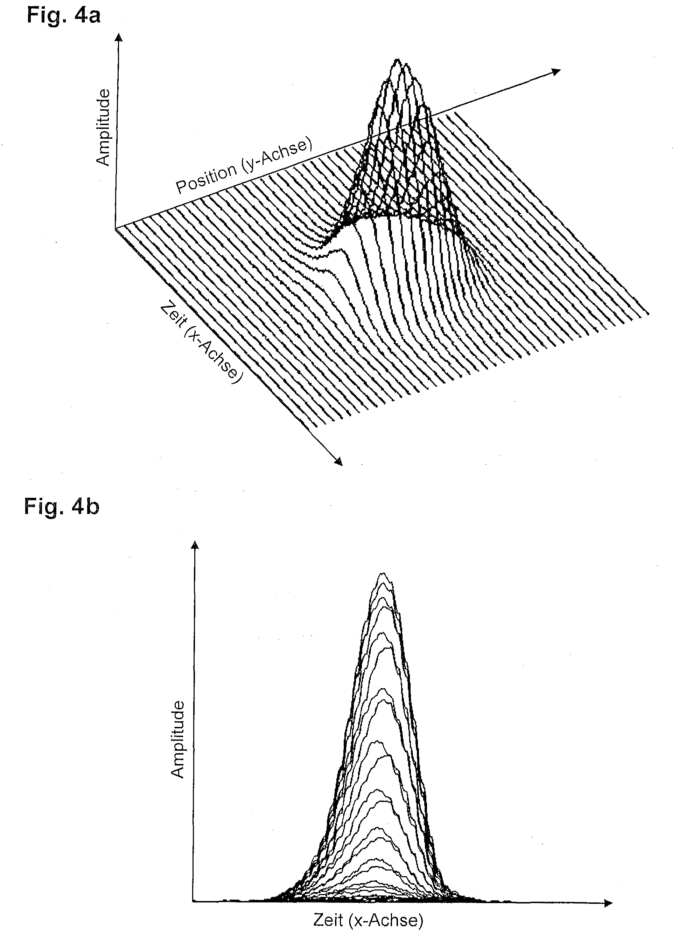

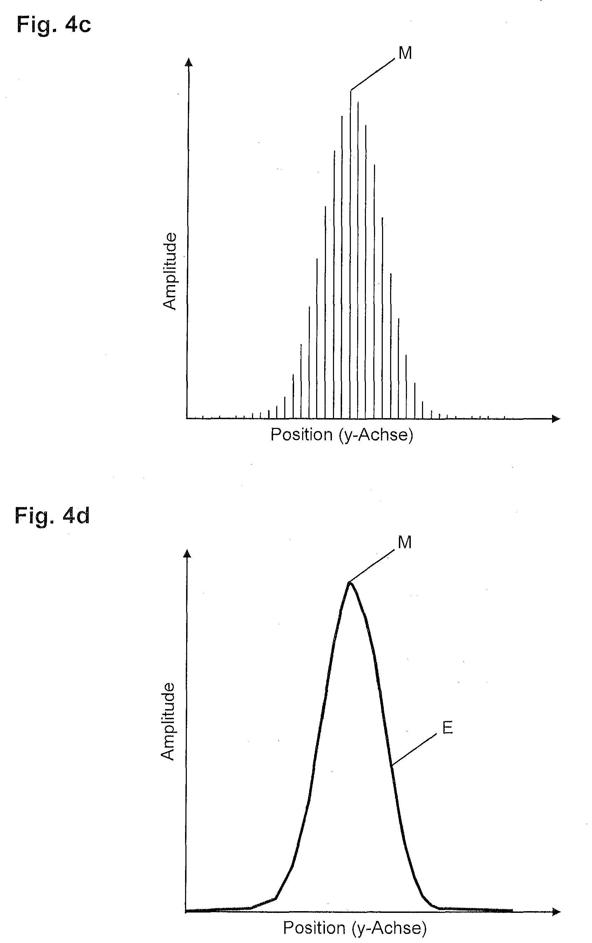

Ein Beispiel für eine Auswertung der einzelnen Signalverläufe ist in Fig. 4 dargestellt. Dabei zeigt Fig. 4a eine perspektivische 3D-Darstellung der gemessenen Signalverläufe. Die Signalverläufe jedes Einzelpulses sind parallel zur Zeitachse aufgetragen, die bei einem Abtasten wie in Fig.3a gezeigt der X-Achse entspricht. Die Signalverläufe verschiedener Einzelpulses sind zueinander in der Positionsachse, die bei einem Abtasten wie in Fig.3a gezeigt der Y-Achse entspricht, um einen Abstand versetzt, der dem in Fig. 3a gezeigten Abstand der Scanvektoren S voneinander entspricht.

Fig. 4b zeigt eine Projektion der 3D-Darstellung auf die Amplitude-Zeit-Ebene. Jede Kurve dieser Kurvenschar stellt einen zeitlichen Signalverlauf s(t) an einer bestimmten Position in der Y-Richtung dar.

Fig. 4c zeigt eine Projektion der 3D-Darstellung auf die Amplitude-Position-Ebene. Da die einzelnen Signalverläufe parallel zu der Zeitachse und damit senkrecht zu der Positionsachse angeordnet sind, ergibt sich in dieser Darstellung für jeden Einzelpuls ein senkrechter Strich, dessen Höhe der Amplitude A des Pulses entspricht.

Fig. 4c zeigt somit eine örtliche Verteilung der Amplituden A abhängig von der Lage der Einzelvektoren in der y-Richtung. Da die Abtastvektoren S zueinander um einen konstanten Betrag in y-Richtung versetzt sind, zeigt diese örtliche Verteilung eine äquidistante Anordnung der Werte der einzelnen Amplituden A auf der y-Achse.

Aus dieser örtlichen Verteilung wird nunmehr das Maximum M ermittelt. Dazu kann am einfachsten, wie in Fig. 4c gezeigt, der Vektor S mit der größten Amplitude A gewählt werden. Insbesondere bei symmetrischer Verteilung, d.h. wenn die beiden nächstkleineren Vektoren auf beiden Seiten dieselbe Länge haben, kann davon ausgegangen werden, dass der Vektor mit der maximalen Länge der y-Koordinate zugeordnet ist, die dem Mittelpunkt der Blendenöffnung entspricht.

Es kann aber auch die Reihe der ermittelten Amplituden A mittels eines an sich bekannten Verfahrens interpoliert werden, beispielsweise mit Splines, woraus sich eine Einhüllende E ergibt, wie sie in Fig. 4d gezeigt ist. Aus der sich ergebenden Einhüllenden E kann das Maximum M und daraus die y-Koordinate des Mittelpunkts der Blendenöffnung ermittelt werden. Es können aber auch die Flanken ausgewertet und daraus die y-Koordinate des Mittelpunkts der Blendenöffnung ermittelt werden, beispielsweise aus dem arithmetischen Mittel der beiden Positionen, bei denen die Einhüllende 50% (oder einen anderen Prozentsatz) ihres Maximums aufweist. Wenn wie in dem in Fig.4c gezeigten Beispiel der linke Nachbar des Pulses mit der maximalen Amplitude eine größere Amplitude hat als der rechte Nachbar, wird das Maximum M der Einhüllenden E wie in Fig. 4d gezeigt zwischen dem Puls mit der maximalen Amplitude und einem linken Nachbarn liegen. Durch das Bilden der Einhüllenden kann also die Genauigkeit des Messvorgangs verbessert werden.

Eine örtliche Verteilung, wie sie in Fig. 4c gezeigt ist, kann aber auch aus den messtechnisch ermittelten Längen L der Einzelpulse P erstellt werden. Dabei entsprechen die Höhen der einzelnen senkrechten Striche nicht den Amplituden A der zugeordneten Pulse P, sondern deren Längen L. Aus dieser örtlichen Verteilung der Längen L wird die y-Koordinate des Mittelpunkts der Blendenöffnung auf dieselbe Weise ermittelt wie oben für die Amplituden A beschrieben.

Nachdem auf diese Weite die y-Koordinate des Mittelpunkts der Blendenöffnung ermittelt wurde, wird auf gleiche Weise durch Abtasten der Blendenöffnung in y-Richtung mit Einzelvektoren, die in x-Richtung gegeneinander versetzt sind, die x-Koordinate des Mittelpunkts der Blendenöffnung ermittelt.

Anschließend kann eine weitere Blendenöffnung in gleicher Weise abgetastet und die x- und y-Koordinate ihres Mittelpunkts ermittelt werden.

Sind alle gewünschten Blendenöffnungen vermessen, fährt der Beschichter 16 in seiner Bewegungsrichtung B zu einer weiteren vorbestimmten Position und bleibt dort stehen. Dann können wieder eine oder mehrere Blendenöffnungen in gleicher Weise vermessen werden. Das wird solange wiederholt, bis alle für die Kalibrierung gewünschten Messungen durchgeführt sind. Das kann von der Vermessung einer einzigen Blendenöffnung an einer bestimmten Position des Beschichters bis hin zur Vermessung aller Blendenöffnungen an einer Mehrzahl von Positionen des Beschichters gehen.

Die so ermittelten x- und y-Koordinaten der Mittelpunkte der Blendenöffnungen entsprechen dem Belichtungskoordinatensystem, d.h. den Positionseinstellungen der Belichtungsvorrichtung, also z.B. bei einer Ablenkvorrichtung mit Galvanometerspiegeln den Stellungen der beiden Galvanometerspiegel.

Andererseits sind die x- und y-Koordinaten der Mittelpunkte der Blendenöffnungen im Maschinenkoordinatensystem, d.h. einem fest mit dem Baufeld verbundenen Koordinatensystem, bekannt aus der geometrischen Anordnung der Blendenöffnungen auf der Blendenleiste und den vorbestimmten Positionen, in die der Beschichter fährt.

Aus einem Vergleich der ermittelten Koordinaten im Belichtungskoordinatensystem mit den bekannten Koordinaten im Maschinenkoordinatensystem können Abweichungen erkannt und daraus Korrekturdaten für die Belichtungsvorrichtung berechnet werden.

Bei dem beschriebenen Verfahren wird die y-Koordinate des Mittelpunkts der Blendenöffnung durch wiederholtes Abtasten des Blendenlochs in x-Richtung ermittelt, die x-Koordinate durch wiederholtes Abtasten des Blendenlochs in y-Richtung. Dadurch ist es möglich, die Positionsbestimmung des Mittelpunkts der Blendenöffnung unabhängig vom Timing der Vektoren, einem Schleppverzug oder anderen Verzögerungen sowie anderen Zeitfaktoren durchzuführen, wodurch die Genauigkeit der Messung erhöht wird.

Die Koordinaten werden also nicht direkt aus den Daten jeden Vektors selber (z.B. Amplitude, Länge oder Zeitlage des entsprechenden Pulses) ermittelt, sondern aus der örtlichen Verteilung der Amplituden bzw. Längen der Einzelpulse senkrecht zu der Abtastrichtung der entsprechenden Vektoren. Anders ausgedrückt wird nicht der sich ständig ändernde Zustand des bewegten Galvanometerspiegels ausgewertet, der die Abtastvektoren erzeugt, sondern der während jedes Abtastvorgangs statische (eingeschwungene) Zustand des feststehenden Spiegels, der nur zum Umschalten zwischen den Abtastvektoren bewegt wird. Daher beeinträchtigen zeitliche Verzögerungen u.ä. des bewglichen Galvanometerspiegels die Genauigkeit der Messung nicht.

Der Zeitabstand zwischen den einzelnen Vektoren ist dagegen groß genug, dass die räumliche Koordinate (z.B. die y-Koordinate bei Abtastung in x-Richtung) eindeutig einem entsprechenden Vektor zugeordnet werden kann.

Nach dem Erzeugen der Korrekturdaten für die Belichtungsvorrichtung ist sichergestellt, dass bei einer Ansteuerung der Belichtungsvorrichtung mit einer bestimmten Koordinate der Belichtungsvorrichtung der Laserstrahl tatsächlich exakt auf den entsprechenden Punkt des Maschinenkoordinatensystems gerichtet wird. Bei Vermessen lediglich einer Blendenöffnung kann nur global ein Versatz in x- und/oder y-Richtung korrigiert werden. Bei zwei Blendenöffnungen können zusätzlich eine Verdrehung und eine Skalierung (Maßstabsfaktor) korrigiert werden. Je mehr Blendenöffnungen vermessen werden, umso besser können auch globale und/oder lokale Verzerrungen korrigiert werden.

Nach dem Kalibrieren der Belichtungsvorrichtung kann die Kalibrierleiste auch dazu verwendet werden einen Fokusdurchmesser des Laserstrahls auszumessen. Dazu wird eine Blendenöffnung durch den Laserstrahl mit einer vorbestimmten Abtastgeschwindigkeit so abgetastet, dass der Abtastvektor durch den Mittelpunkt der Blendenöffnung verläuft. Das Ausgangssignal des Flächensensors hat dabei einen ähnlichen Verlauf, wie er in Fig. 3b dargestellt ist. Die Zeitdauer des entsprechenden Pulses des Ausgangssignals wird gemessen, beispielsweise bei einer Schwelle von 90 bis 95% des Maximalpegels, und aus der gemessenen Zeitdauer und der vorbestimmten Abtastgeschwindigkeit wird der Fokusdurchmessers des Laserstrahls berechnet. In diese Berechnung geht ein theoretisches Modell des Laserstrahlprofils (z.B. Gaußprofil) ein. Durch einen Vergleich des gemessenen Signalverlaufs mit dem beim Überfahren der Blende mit einer festen Geschwindigkeit entsprechend dem Modell des Laserstrahls berechneten Signalverlauf kann der Fokusdurchmessers des Laserstrahls bestimmt werden.

Durch Anordnung einer Mehrzahl von Blendenöffnungen in der Blendenleiste und Bewegen der Kalibrierleiste über das Baufeld kann auch eine Verteilung des Fokusdurchmessers über das Baufeld bestimmt werden, bei Höhenverstellbarkeit des Beschichters bzw. der Kalibrierleiste auch in mehreren Ebenen.

In der oben beschriebenen Ausführungsform sind die Blendenöffnungen als Durchgangsbohrungen in einem für die verwendete Strahlung im Wesentlichen undurchlässigen Material gebildet. Alternativ dazu kann die Blendenleiste aber auch aus einem für die Strahlung durchlässigen Material gebildet sein, auf dem eine Maske aus einem Strahlung undurchlässigen Material gebildet ist, in dem die Blendenöffnungen freigelassen sind, beispielsweise aus einem Glassubstrat mit einer Chrommaske. In diesem Fall sollte die Maske für die verwendete Strahlung bei senkrechtem Strahlungseinfall zumindest 10-mal weniger durchlässig sein als das Trägersubstrat, vorzugsweise zumindest 100-mal und in weiter bevorzugter Weise zumindest 1000-mal.

Die Blendenöffnungen müssen auch nicht wie in dem oben beschriebenen Ausführungsbeispiel größer sein als der Fokusdurchmesser des Laserstrahls, sondern sie können auch kleiner sein. Beispielsweise können bei einem für einen CO₂-Laser typischen Fokusdurchmesser von 0,5 mm Blendenöffnungen von 0.4 mm verwende werden. Auch in diesem Fall ergibt sich eine unterschiedliche Länge der Einzelvektoren und daraus die Möglichkeit, über eine Verteilung der Vektorlängen die Koordinate des Mittelpunkts der Blendenöffnung zu bestimmen. Vorzugsweise liegt der Durchmesser der Blendenöffnung in einem Bereich von einem Zehntel bis zum Zehnfachen des Fokusdurchmessers des Laserstrahls, der beispielsweise durch die Halbwertsbreite der Intensitätsverteilung des Laserstrahlprofils definiert ist.

Außer der beschriebenen Kreisform können die Blendenöffnungen auch eine andere Form haben, z.B. eine Rautenform, solange sichergestellt ist, dass die Längen der den Einzelvektoren entsprechenden Pulse sich bei einem seitlichen Versatz ändern.

Wenn die verwendete Laserleistung zu hoch ist, so dass die Gefahr einer Beschädigung der Blendenleiste besteht, kann der Laser für die Kalibrierung auch gezielt defokussiert werden. Eine Kalibrierung außerhalb der Fokusebene kann auch dadurch erfolgen, dass die Blendenleiste nicht in die Arbeitsebene gebracht wird, sondern entsprechend darunter oder darüber.

Bei Verwendung mehrerer Flächensensoren können alle Flächensensoren mit derselben Auswerteeinrichtung verbunden sein, beispielsweise indem sie elektrisch in Reihe geschaltet sind. Es können aber auch mehrere Auswerteeinrichtungen bereit gestellt sein, wobei mit jeder Auswerteeinrichtung nur ein Teil der Flächensensoren oder sogar nur ein einziger Flächensensor verbunden ist. Bei Verwendung mehrerer Auswerteeinrichtungen können bei einer Mehrkopfvorrichtung, die mehrere Laserstrahlen gleichzeitig an verschiedene Stellen ausstrahlen kann, auch mehrere Kalibrierungen gleichzeitig durchgeführt werden.

Als Flächensensoren können auch ortsauflösende Sensoren verwendet werden, die nicht nur die Intensität der auf treffenden Strahlung messen, sondern auch den Ort des Auftreffens, bzw. bei einem Durchmesser des Laserstrahl, der sich über mehrere Messepunkte (Pixel) des ortsauflösenden Sensors erstreckt, eine Intensitätsverteilung.

Während die Kalibrierleiste in der oben beschriebenen Ausführungsform an dem Beschichter angebracht ist und mit ihm zusammen bewegt wird, ist die vorliegende Erfindung nicht darauf eingeschränkt. Die Kalibrierleiste kann auch fest in der Vorrichtung eingebaut sein (oder bei Bedarf eingebaut werden) oder getrennt von dem Beschichter bewegbar sein, vorzugsweise quer, in weiter bevorzugter Weise senkrecht zu ihrer Längsrichtung.

Die Kalibrierleiste kann auch zum Kalibrieren von Mehrkopfsystemen verwendet werden, bei denen mehr als ein Laserstrahl gleichzeitig zum Verfestigen des Aufbaumaterials verwendet wird. Die Laserstrahlen können die Blendenöffnungen nacheinander abtasten. Bei Unterteilung des Flächensensors in mehrere Einzelsensoren können aber auch Blendenöffnungen, die verschiedenen Flächensensoren zugeordnet sind, gleichzeitig abgetastet werden.

Auch wenn die vorliegende Erfindung anhand einer Lasersinter- bzw. Laserschmelzvorrichtung beschrieben wurde, ist sie nicht auf das Lasersintern oder Laserschmelzen eingeschränkt. Sie kann auf beliebige Verfahren zum Herstellen eines dreidimensionalen Objektes durch schichtweises Aufbringen und selektives Verfestigen eines Aufbaumaterials mittels Strahlung angewendet werden.

Der Belichter kann beispielsweise einen oder mehrere Gas- oder Festkörperlaser oder jede andere Art von Laser wie z.B. Laserdioden, insbesondere VCSEL (Vertical Cavity Surface Emitting Laser) oder VECSEL (Vertical External Cavity Surface Emitting Laser) umfassen, insbesondere eine Zeile aus diesen Lasern. Allgemein kann als Belichter jede Einrichtung verwendet werden, mit der Energie als Wellen- oder Teilchenstrahlung selektiv auf eine Schicht des Aufbaumaterials aufgebracht werden kann. Anstelle eines Lasers können beispielsweise eine andere Lichtquelle, ein Elektronenstrahl oder jede andere Energie- bzw. Strahlenquelle verwendet werden, die geeignet ist, das Aufbaumaterial zu verfestigen.

Zum Herstellen des Objekts können verschiedene Arten von Aufbaumaterialien verwendet werden, insbesondere Pulver wie z.B. Metallpulver, Kunststoffpulver, Keramikpulver, Sand, gefüllte oder gemischte Pulver.

## Patentansprüche

1. Kalibriervorrichtung (30) zum Kalibrieren einer Herstellvorrichtung (1) zum Herstellen eines dreidimensionalen Objekts (2) innerhalb eines Baufelds (8) durch schichtweises Verfestigen eines Aufbaumaterials (15) an den dem jeweiligen Querschnitt des Objekts entsprechenden Stellen durch selektives Bestrahlen von Schichten des Aufbaumaterials mit einer Strahlung (22) in einer Arbeitsebene (7), wobei die Herstellvorrichtung eine Bestrahlungsvorrichtung (20) aufweist, die in der Lage ist, selektiv eine zur Verfestigung des Aufbaumaterials geeignete Strahlung, vorzugsweise Laserstrahlung, in weiter bevorzugter Weise Strahlung eines Gaslasers, auf verschiedene Stellen der Arbeitsebene innerhalb des Baufelds zu richten,
wobei die Kalibriervorrichtung enthält:
eine Kalibrierleiste (31), die eine längliche Form aufweist,
wobei die Kalibrierleiste eine sich in ihrer Längsrichtung erstreckende Blendenleiste (42) enthält, die eine Mehrzahl von in der Längsrichtung der Kalibrierleiste in einer Reihe angeordneten Blendenöffnungen (43) aufweist, welche für die Strahlung der Bestrahlungsvorrichtung stärker durchlässig sind als der die Blendenöffnungen umgebende Bereich der Blendenleiste,
die Kalibrierleiste ferner eine sich in ihrer Längsrichtung erstreckende, im Wesentlichen parallel zu der Blendenleiste angeordnete Sensorleiste (40) enthält, die zumindest einen Flächensensor (41) enthält, der in der Lage ist, die Strahlung der Bestrahlungsvorrichtung zu detektieren, und
die Kalibrierleiste so in der Herstellvorrichtung anbringbar ist, dass die Strahlung der Bestrahlungsvorrichtung durch die Blendenöffnungen auf den zumindest einen Flächensensor auftreffen kann,
wobei die Kalibrierleiste vorzugsweise so in der Herstellvorrichtung anbringbar ist, dass die Blendenleiste in der Arbeitsebene der Herstellvorrichtung liegt, und
wobei die Kalibriervorrichtung weiter zumindest eine Auswerteeinheit (32) umfasst, die geeignet ist, ein Ausgangssignal (s(t)) des zumindest einen Flächensensors (41) auszuwerten,
wobei die zumindest eine Auswerteeinheit geeignet ist, für eine Blendenöffnung Amplituden A und/oder Längen L von in dem Ausgangssignal enthaltenen Einzelpulsen P zu ermitteln, eine örtliche Verteilung der ermittelten Amplituden und/oder Längen aufzustellen und diese örtliche Verteilung auszuwerten, wobei ein Einzelpuls P ein durch das Abtasten der Blendenöffnung (43) mit einer Strahlung konstanter Intensität entstehender Puls in dem Ausgangssignal (s(t)) des Flächensensors (41) ist.

2. Kalibriervorrichtung (30) nach Anspruch 1, wobei die Blendenöffnungen (43) für die Strahlung (22) der Bestrahlungsvorrichtung (20) zumindest 10-mal, vorzugsweise 100-mal, in weiter bevorzugter Weise zumindest 1000-mal stärker durchlässig sind als der die Blendenöffnungen umgebende Bereich der Blendenleiste (42).

3. Kalibriervorrichtung (30) nach Anspruch 1 oder 2, wobei die Blendenöffnungen (43) in der Richtung zu der Sensorleiste (40) hin verbreitert sind und/oder einen Durchmesser haben, der im Bereich von einem Zehntel bis zum Zehnfachen des Fokusdurchmessers der Strahlung (22) der Bestrahlungsvorrichtung (20) liegt.

4. Kalibriervorrichtung (30) nach einem der Ansprüche 1 bis 3, wobei die Sensorleiste (40) eine Mehrzahl von Flächensensoren (41) aufweist, die in der Längsrichtung der Kalibrierleiste hintereinander angeordnet sind.

5. Kalibriervorrichtung (30) nach einem der Ansprüche 1 bis 4, wobei der zumindest eine Flächensensor (41) oder zumindest einer aus der Mehrzahl von Flächensensoren, bevorzugt jeder aus der Mehrzahl von Flächensensoren, eine Ausdehnung in der Längsrichtung der Kalibrierleiste aufweist, die größer ist als der Abstand zwischen zwei benachbarten Blendenöffnungen (43).

6. Kalibriervorrichtung (30) nach einem der Ansprüche 1 bis 5, wobei der zumindest eine Flächensensor (41) oder zumindest einer aus der Mehrzahl von Flächensensoren ein ortsauflösender Sensor ist.

7. Kalibriervorrichtung (30) nach einem der Ansprüche 4 bis 6, wobei zumindest eine Auswerteeinheit (32) mit mehr als einem Flächensensor (41) der Kalibrierleiste verbunden ist,
wobei vorzugsweise die mit derselben Auswerteeinheit verbundenen Flächensensoren elektrisch in Reihe geschaltet sind.

8. Kalibriervorrichtung (30) nach einem der Ansprüche 4 bis 6, wobei die Kalibriervorrichtung für jeden aus der Mehrzahl von Flächensensoren (41) eine eigene Auswerteeinheit (32) enthält.

9. Herstellvorrichtung (1) zum Herstellen eines dreidimensionalen Objekts (2) durch schichtweises Verfestigen eines Aufbaumaterials (15) innerhalb eines Baufelds (8) an den dem jeweiligen Querschnitt des Objekts entsprechenden Stellen durch selektives Bestrahlen von Schichten des Aufbaumaterials mit einer Strahlung (22) in einer Arbeitsebene (7), wobei die Herstellvorrichtung enthält:
eine Bestrahlungsvorrichtung (20), die in der Lage ist, selektiv eine zur Verfestigung des Aufbaumaterials geeignete Strahlung, vorzugsweise Laserstrahlung, in weiter bevorzugter Weise Strahlung eines Gaslasers, auf verschiedene Stellen der Arbeitsebene innerhalb des Baufelds zu richten, und
eine Kalibriervorrichtung (30) nach einem der Ansprüche 1 bis 8,
wobei die Kalibrierleiste so in der Herstellvorrichtung angeordnet ist, dass die Strahlung der Bestrahlungsvorrichtung durch die Blendenöffnungen (43) auf den zumindest einen Flächensensor (41) auftreffen kann, und vorzugsweise so, dass die Blendenleiste (42) in der Arbeitsebene der Herstellvorrichtung liegt,
wobei vorzugsweise die Kalibrierleiste bewegbar in der Herstellvorrichtung angeordnet ist, in weiter bevorzugter Weise quer zu ihrer Längsrichtung bewegbar und in noch weiter bevorzugter Weise senkrecht zu ihrer Längsrichtung bewegbar.

10. Herstellvorrichtung (1) nach Anspruch 9, die weiter einen sich in einer Bewegungsrichtung (B) über das Baufeld bewegbaren Beschichter (16) zum Aufbringen einer Schicht des Aufbaumaterials (15) auf das Baufeld (8) enthält,
wobei die Kalibrierleiste (31) an dem Beschichter und mit diesem gemeinsam bewegbar so angebracht ist, dass ihre Längsrichtung sich quer, vorzugsweise senkrecht zu der Bewegungsrichtung des Beschichters erstreckt.

11. Kalibrierverfahren zum Kalibrieren einer Herstellvorrichtung (1) zum Herstellen eines dreidimensionalen Objekts (2) innerhalb eines Baufelds (8) durch schichtweises Verfestigen eines Aufbaumaterials (15) an den dem jeweiligen Querschnitt des Objekts entsprechenden Stellen durch selektives Bestrahlen von Schichten des Aufbaumaterials mit einer Strahlung (22) in einer Arbeitsebene (7), wobei die Herstellvorrichtung eine Bestrahlungsvorrichtung (20) aufweist, die in der Lage ist, selektiv eine zur Verfestigung des Aufbaumaterials geeignete Strahlung, vorzugsweise Laserstrahlung, in weiter bevorzugter Weise Strahlung eines Gaslasers, auf verschiedene Stellen der Arbeitsebene innerhalb des Baufelds zu richten, wobei das Verfahren die folgenden Schritte aufweist:
Anbringen einer Kalibrierleiste (31) einer Kalibriervorrichtung (30) gemäß einem der Ansprüche 1 bis 8 innerhalb der Herstellvorrichtung dergestalt, dass die Strahlung der Bestrahlungsvorrichtung durch die Blendenöffnungen (43) auf den zumindest einen Flächensensor (41) auftreffen kann, und vorzugsweise so, dass die Blendenleiste (42) in der Arbeitsebene der Herstellvorrichtung liegt,
Abtasten zumindest einer Blendenöffnung der Kalibrierleiste durch die Strahlung der Bestrahlungsvorrichtung,
Erfassen eines Ausgangssignals (s(t)) des zumindest einen Flächensensors,
Ermitteln der Position des Mittelpunkts der zumindest einen Blendenöffnung in einem Bestrahlungskoordinatensystem aus dem erfassten Ausgangssignal,
Vergleichen der Position des Mittelpunkts der zumindest einen Blendenöffnung in dem Bestrahlungskoordinatensystem mit einer bekannten Position des Mittelpunkts der Blendenöffnung in einem fest mit dem Baufeld verbundenen Maschinenkoordinatensystem und
Berechnen von Korrekturdaten für die Bestrahlungsvorrichtung aus dem Ergebnis des Vergleichs,
wobei vorzugsweise zwei oder mehr Blendenöffnungen der Kalibrierleiste von der Strahlung der Bestrahlungsvorrichtung abgetastet und ihre Positionen in dem Bestrahlungskoordinatensystem ermittelt werden und/oder
die Kalibrierleiste vorzugsweise quer zu ihrer Längsrichtung, in weiter bevorzugter Weise senkrecht zu ihrer Längsrichtung über das Baufeld bewegt wird und in zumindest einer weiteren Position der Kalibrierleiste zumindest eine Blendenöffnung von der Strahlung der Bestrahlungsvorrichtung abgetastet und ihre Position in dem Bestrahlungskoordinatensystem ermittelt wird.

12. Kalibrierverfahren gemäß Anspruch 11, bei dem
der Schritt des Abtastens zumindest einer Blendenöffnung (43) einen ersten Schritt enthält des Abtastens der Blendenöffnung durch die Strahlung (22) der Bestrahlungsvorrichtung (22) in Form von Vektoren (S), die parallel zueinander in eine erste Richtung (x) oder deren Gegenrichtung verlaufen und voneinander beabstandet sind, und einen zweiten Schritt des Abtastens der Blendenöffnung durch die Strahlung der Bestrahlungsvorrichtung in Form von Vektoren, die parallel zueinander in eine zweite Richtung (y) oder deren Gegenrichtung verlaufen und voneinander beabstandet sind, wobei die zweite Richtung quer, vorzugsweise senkrecht zu der ersten Richtung ist,
der Schritt des Erfassen eines Ausgangssignals (s(t)) des zumindest einen Flächensensors (41) für jeden der beiden Abtastschritte das Ermitteln von Amplituden (A) und/oder Längen (L) einzelner Pulse (P), die den Vektoren entsprechen, enthält, und
der Schritt des Ermittelns des Mittelpunkts der Blendenöffnung in dem Bestrahlungskoordinatensystem für jeden der beiden Abtastschritte das Aufstellen einer örtlichen Verteilung der ermittelten Amplituden und/oder Längen und das Auswerten dieser örtlichen Verteilung enthält.

13. Kalibrierverfahren gemäß Anspruch 11 oder 12, das zusätzlich nach dem Kalibrieren der Bestrahlungsvorrichtung (20) das Messen eines Fokusdurchmessers einer von der Bestrahlungsvorrichtung abgegebenen Strahlung (22) enthält mit den Schritten:
Abtasten einer Blendenöffnung (43) der Kalibrierleiste (31) durch die Strahlung der Bestrahlungsvorrichtung in Form eines Abtastvektors (S), der durch den Blendenmittelpunkt geht, mit einer vorbestimmten Abtastgeschwindigkeit,
Messen einer Zeitdauer eines Pulses (P) des Ausgangssignals (s(t)) des Flächensensors,
Berechnen des Fokusdurchmessers der Strahlung aus der gemessenen Zeitdauer und der vorbestimmten Abtastgeschwindigkeit.

14. Herstellverfahren zum Herstellen eines dreidimensionalen Objekts (2) innerhalb eines Baufelds (8) mit den Schritten:
Auftragen einer Schicht eines Aufbaumaterials (15) mit einem Beschichter (16) durch Bewegen des Beschichters über das Baufeld;
Verfestigen der Schicht des Aufbaumaterials an den dem jeweiligen Querschnitt des Objekts entsprechenden Stellen durch selektives Bestrahlen mit einer zur Verfestigung des Aufbaumaterials geeigneten Strahlung (22), vorzugsweise Laserstrahlung, in weiter bevorzugter Weise Strahlung eines Gaslasers, innerhalb des Baufelds; und
Wiederholen der Schritte des Auftragens und des Verfestigens, bis das dreidimensionale Objekt fertiggestellt ist,
wobei zumindest einmal vor dem Herstellverfahren oder während des Herstellverfahrens ein Kalibrierverfahren gemäß einem der Ansprüche 11 bis 13 durchgeführt wird.

## Claims

1. A calibration device (30) for calibrating a manufacturing device (1) for manufacturing a three-dimensional object (2) within a build area (8) by a layer-by-layer solidification of a building material (15) at the points corresponding to the respective cross-section of the object by selectively irradiating layers of the building material with a radiation (22) in a working plane (7), wherein the manufacturing device comprises an irradiation device (20) capable of selectively directing a radiation suitable for solidifying the building material, preferably laser radiation, radiation of a gas laser being further preferred, to different points of the working plane within the build area,
wherein the calibration device comprises:
a calibration ledge (31) having an elongated shape,
wherein the calibration ledge comprises an aperture ledge (42) extending in its longitudinal direction and comprising several aperture openings (43) arranged in a row in the longitudinal direction of the calibration ledge which are more permeable for the radiation of the irradiation device than the region of the aperture ledge surrounding the aperture openings,
the calibration ledge further comprises a sensor ledge (40) extending in its longitudinal direction, arranged substantially parallel to the aperture ledge, and comprising at least one surface sensor (41) capable of detecting the radiation of the irradiation device, and
the calibration ledge is mountable in the manufacturing device such that the radiation of the irradiation device can hit the at least one surface sensor through the aperture openings,
wherein the calibration ledge is preferably mountable in the manufacturing device such that the aperture ledge lies in the working plane of the manufacturing device, and
wherein the calibration device further comprises at least one evaluation unit (32) suitable for evaluating an output signal (s(t)) of the at least one surface sensor (41),
wherein the at least one evaluation unit is suitable for determining for one aperture opening amplitudes A and/or lengths L of single pulses P contained in the output signal, setting up a spatial distribution of the determined amplitudes and/or lengths, and evaluating this spatial distribution, wherein a single pulse P is a pulse in the output signal (s(t)) of the surface sensor (41) that is generated by scanning the aperture opening (43) by a radiation of constant intensity.

2. The calibration device (30) according to claim 1, wherein the aperture openings (43) are at least 10 times, preferably 100 times, further preferred at least 1000 times more permeable for the radiation (22) of the irradiation device (20) than the region of the aperture ledge (42) surrounding the aperture openings.

3. The calibration device (30) according to claim 1 or 2, wherein the aperture openings (43) are widened in the direction towards the sensor ledge (40) and/or have a diameter in the range from a tenth to the tenfold of the focal diameter of the radiation (22) of the irradiation device (20).

4. The calibration device (30) according to one of claims 1 to 3, wherein the sensor ledge (40) comprises several surface sensors (41) arranged in a row in the longitudinal direction of the calibration ledge.

5. The calibration device (30) according to one of claims 1 to 4, wherein the at least one surface sensor (41) or at least one of said several surface sensors, preferably each one of said several surface sensors, has an extension in the longitudinal direction of the calibration ledge which is greater than the distance between two neighbouring aperture openings (43).

6. The calibration device (30) according to one of claims 1 to 5, wherein the at least one surface sensor (41) or at least one of said several surface sensors is a spatially resolving sensor.

7. The calibration device (30) according to one of claims 4 to 6, wherein at least one evaluation unit (32) is connected to more than one surface sensor (41) of the calibration ledge,
wherein, preferably, the surface sensors connected to the same evaluation unit are electrically connected in series.

8. The calibration device (30) according to one of claims 4 to 6, wherein the calibration device contains an individual evaluation unit (32) for each of said several surface sensors (41).

9. A manufacturing device (1) for manufacturing a three-dimensional object (2) by a layer-by-layer solidification of a building material (15) within a build area (8) at the points corresponding to the respective cross-section of the object by selectively irradiating layers of the building material with a radiation (22) in a working plane (7), wherein the manufacturing device comprises:
an irradiation device (20) capable of selectively directing a radiation suitable for solidifying the building material, preferably laser radiation, radiation of a gas laser being further preferred, to different points of the working plane within the build area, and
a calibration device (30) according to one of claims 1 to 8,
wherein the calibration ledge is arranged in the manufacturing device such that the radiation of the irradiation device can hit the at least one surface sensor (41) through the aperture openings (43), and preferably such that the aperture ledge (42) lies in the working plane of the manufacturing device,
wherein, preferably, the calibration ledge is movably arranged in the manufacturing device, being in a further preferred manner movable transversely to its longitudinal direction and being in a still further preferred manner movable perpendicularly to its longitudinal direction.

10. The manufacturing device (1) according to claim 9, further comprising a recoater (16) movable across the build area in a movement direction (B) for applying a layer of the building material (15) to the build area (8),
wherein the calibration ledge (31) is mounted at the recoater and being movable together with it such that its longitudinal direction extends transversely, preferably perpendicularly to the movement direction of the recoater.

11. A calibration method for calibrating a manufacturing device (1) for manufacturing a three-dimensional object (2) within a build area (8) by a layer-by-layer solidification of a building material (15) at the points corresponding to the respective cross-section of the object by selectively irradiating layers of the building material with a radiation (22) in a working plane (7), wherein the manufacturing device comprises an irradiation device (20) capable of selectively directing a radiation suitable for solidifying the building material, preferably laser radiation, radiation of a gas laser being further preferred, to different points of the working plane within the build area, wherein the method comprises the following steps:
mounting a calibration ledge (31) of a calibration device (30) according to one of claims 1 to 8 inside the manufacturing device such that the radiation of the irradiation device can hit the at least one surface sensor (41) through the aperture openings (43), and preferably such that the aperture ledge (42) lies in the working plane of the manufacturing device,
scanning at least one aperture opening of the calibration ledge by the radiation of the irradiation device,
capturing an output signal (s(t)) of the at least one surface sensor,
determining the position of the centre of the at least one aperture opening in an irradiation coordinate system from the captured output signal,
comparing the position of the centre of the at least one aperture opening in the irradiation coordinate system with a known position of the centre of the aperture opening in a machine coordinate system permanently fixed to the build area, and
calculating correction data for the irradiation device from the result of the comparison,
wherein, preferably, two or more aperture openings of the calibration ledge are scanned by the radiation of the irradiation device and their positions in the irradiation coordinate system are determined and/or
the calibration ledge is preferably moved transversely to its longitudinal direction, in a further preferred manner perpendicularly to its longitudinal direction across the build area, and in at least one further position of the calibration ledge at least one aperture opening is scanned by the radiation of the irradiation device and its position in the irradiation coordinate system is determined.

12. The calibration method according to claim 11, wherein
the step of scanning at least one aperture opening (43) includes a first step of scanning of the aperture opening by the radiation (22) of the irradiation device (22) in the form of vectors (S) running parallel to each other in a first direction (x) or the direction opposite to that and having a distance from each other, and a second step of scanning of the aperture opening by the radiation of the irradiation device in the form of vectors running parallel to each other in a second direction (y) or the direction opposite to that and having a distance from each other, wherein the second direction is transverse, preferably perpendicular to the first direction,
the step of capturing an output signal (s(t)) of the at least one surface sensor (41) includes, for each of the two scanning steps, determining amplitudes (A) and/or lengths (L) of single pulses (P) corresponding to the vectors, and
the step of determining the centre of the aperture opening in the irradiation coordinate system includes, for each of the two scanning steps, setting up a spatial distribution of the determined amplitudes and/or lengths and evaluating this spatial distribution.

13. The calibration method according to claim 11 or 12, additionally including, after the calibration of the irradiation device (20), the measurement of a focal diameter of a radiation (22) emitted by the irradiation device comprising the steps of:
scanning an aperture opening (43) of the calibration ledge (31) by the radiation of the irradiation device in the form of a scanning vector (S) going through the aperture centre, at a predetermined scanning speed,
measuring a duration of a pulse (P) of the output signal (s(t)) of the surface sensor,
calculating the focal diameter of the radiation from the measured duration and the predetermined scanning speed.

14. A manufacturing method for manufacturing a three-dimensional object (2) within a build area (8), comprising the steps of:
applying a layer of a building material (15) using a recoater (16) by moving the recoater across the build area;
solidifying the layer of the building material at the points corresponding to the respective cross-section of the object by selectively irradiating it with a radiation (22) suitable for solidifying the building material, preferably laser radiation, radiation of a gas laser being further preferred, within the build area; and
repeating the steps of applying and solidifying until the three-dimensional object is completed,
wherein a calibration method according to one of claims 11 to 13 is carried out at least once before the manufacturing method or during the manufacturing method.

## Revendications

1. Dispositif d'étalonnage (30) destiné à l'étalonnage d'un dispositif de fabrication (1) pour fabriquer un objet (2) tridimensionnel à l'intérieur d'un champ de construction (8) par solidification par couches d'un matériau de construction (15) au niveau des emplacements correspondant à la section transversale respective de l'objet par irradiation sélective de couches du matériau de construction avec un rayonnement (22) dans un plan de travail (7), dans lequel le dispositif de fabrication présente un dispositif d'irradiation (20) qui est en mesure de diriger sélectivement un rayonnement adapté pour solidifier le matériau de construction, de préférence un rayonnement laser, de manière encore plus préférée un rayonnement d'un laser à gaz, sur différents emplacements du plan de travail à l'intérieur du champ de construction,
dans lequel le dispositif d'étalonnage contient :
une barrette d'étalonnage (31) qui présente une forme oblongue,
dans lequel la barrette d'étalonnage contient une barrette d'obturation (42) s'étendant dans sa direction longitudinale et qui présente une pluralité d'ouvertures d'obturation (43) agencées en une rangée dans la direction longitudinale de la barrette d'étalonnage, lesquelles, pour le rayonnement du dispositif d'irradiation, sont plus perméables que la zone entourant les ouvertures d'obturation de la barrette d'étalonnage,
la barrette d'étalonnage contient en outre une barrette de capteurs (40) s'étendant dans sa direction longitudinale et agencée essentiellement en parallèle à la barrette d'obturation, laquelle barrette de capteurs contient au moins un capteur de surface (41) qui est en mesure de détecter le rayonnement du dispositif d'irradiation, et
la barrette d'étalonnage peut être montée dans le dispositif de fabrication de telle sorte que le rayonnement du dispositif d'irradiation puisse arriver sur le au moins un capteur de surface par les ouvertures d'obturation,
dans lequel la barrette d'étalonnage peut être montée dans le dispositif de fabrication de préférence de telle sorte que la barrette d'obturation se situe dans le plan de travail du dispositif de fabrication, et
dans lequel le dispositif d'étalonnage comprend par ailleurs au moins une unité d'exploitation (32) qui est adaptée pour exploiter un signal de sortie (s(t)) du au moins un capteur de surface (41),
dans lequel la au moins une unité d'exploitation est adaptée pour déterminer, pour une ouverture d'obturation, des amplitudes A et/ou des longueurs L d'impulsions uniques P contenues dans le signal de sortie, pour mettre en place une distribution locale des amplitudes et/ou longueurs déterminées et pour exploiter cette distribution locale, dans lequel une impulsion unique P est une impulsion dans le signal de sortie (s(t)) du capteur de surface (41), née du balayage de l'ouverture d'obturation (43) avec un rayonnement d'un intensité constante.

2. Dispositif d'étalonnage (30) selon la revendication 1, dans lequel les ouvertures d'obturation (43) pour le rayonnement (22) du dispositif d'irradiation (20) sont au moins 10 fois, de préférence 100 fois, de manière encore plus préférée au moins 1 000 fois plus perméables que la zone entourant les ouvertures d'obturation de la barrette d'obturation (42).

3. Dispositif d'étalonnage (30) selon la revendication 1 ou 2, dans lequel les ouvertures d'obturation (43) sont élargies dans la direction allant vers la barrette de capteurs (40) et/ou ont un diamètre qui se situe dans la plage allant d'un dixième jusqu'à dix fois le diamètre focal du rayonnement (22) du dispositif d'irradiation (20).

4. Dispositif d'étalonnage (30) selon l'une des revendications 1 à 3, dans lequel la barrette de capteurs (40) présente une pluralité de capteurs de surface (41) qui sont agencés les uns derrière les autres dans la direction longitudinale de la barrette d'étalonnage.

5. Dispositif d'étalonnage (30) selon l'une des revendications 1 à 4, dans lequel le au moins un capteur de surface (41) ou au moins l'un parmi la pluralité de capteurs de surface, de préférence chacun de la pluralité de capteurs de surface, présente une extension dans la direction longitudinale de la barrette d'étalonnage qui est plus grande que l'espacement entre deux ouvertures d'obturation (43) avoisinantes.

6. Dispositif d'étalonnage (30) selon l'une des revendications 1 à 5, dans lequel le au moins un capteur de surface (41) ou au moins l'un parmi la pluralité de capteurs de surface est un capteur à résolution locale.

7. Dispositif d'étalonnage (30) selon l'une des revendications 4 à 6, dans lequel au moins une unité d'exploitation (32) est raccordée à plus d'un capteur de surface (41) de la barrette d'étalonnage,
dans lequel les capteurs de surface raccordés à la même unité d'exploitation sont de préférence montés électriquement en série.

8. Dispositif d'étalonnage (30) selon l'une des revendications 4 à 6, dans lequel le dispositif d'étalonnage contient une unité d'exploitation (32) propre à chacun de la pluralité de capteurs de surface (41).

9. Dispositif de fabrication (1) destiné à fabriquer un objet (2) tridimensionnel par solidification par couches d'un matériau de construction (15) à l'intérieur d'un champ de construction (8) au niveau des emplacements correspondant à la section transversale respective de l'objet par irradiation sélective de couches du matériau de construction avec un rayonnement (22) dans un plan de travail (7), dans lequel le dispositif de fabrication contient :
un dispositif d'irradiation (20) qui est en mesure de diriger sélectivement un rayonnement adapté pour solidifier le matériau de construction, de préférence un rayonnement laser, de manière encore plus préférée un rayonnement d'un laser à gaz, sur différents emplacements du plan de travail à l'intérieur du champ de construction, et
un dispositif d'étalonnage (30) selon l'une des revendications 1 à 8,
dans lequel la barrette d'étalonnage est agencée dans le dispositif de fabrication de telle sorte que le rayonnement du dispositif d'irradiation puisse arriver sur le au moins un capteur de surface (41) par les ouvertures d'obturation (43), et de préférence de telle sorte que la barrette d'obturation (42) se situe dans le plan de travail du dispositif de fabrication,
dans lequel la barrette d'étalonnage est agencée de préférence de façon déplaçable dans le dispositif de fabrication, de manière plus préférée de façon déplaçable transversalement à sa direction longitudinale et de manière encore plus préférée de façon déplaçable perpendiculairement à sa direction longitudinale.

10. Dispositif de fabrication (1) selon la revendication 9, qui contient en outre un enducteur (16) déplaçable dans une direction de déplacement (B) par-dessus le champ de construction pour l'application d'une couche du matériau de construction (15) sur le champ de construction (8),
dans lequel la barrette d'étalonnage (31) est montée au niveau de l'enducteur et déplaçable ensemble avec celui-ci de telle sorte que sa direction longitudinale s'étende transversalement, de préférence perpendiculairement à la direction de déplacement de l'enducteur.

11. Procédé d'étalonnage destiné à l'étalonnage d'un dispositif de fabrication (1) pour fabriquer un objet (2) tridimensionnel à l'intérieur d'un champ de construction (8) par solidification par couches d'un matériau de construction (15) au niveau des emplacements correspondant à la section transversale respective de l'objet par irradiation sélective de couches du matériau de construction avec un rayonnement (22) dans un plan de travail (7), dans lequel le dispositif de fabrication présente un dispositif d'irradiation (20) qui est en mesure de diriger sélectivement un rayonnement adapté pour solidifier le matériau de construction, de préférence un rayonnement laser, de manière encore plus préférée un rayonnement d'un laser à gaz, sur différents emplacements du plan de travail à l'intérieur du champ de construction, dans lequel le procédé présente les étapes suivantes :
montage d'une barrette d'étalonnage (31) d'un dispositif d'étalonnage (30) selon l'une des revendications 1 à 8 à l'intérieur du dispositif de fabrication de telle sorte que le rayonnement du dispositif d'irradiation puisse arriver sur le au moins un capteur de surface (41) par les ouvertures d'obturation (43), et de préférence de telle sorte que la barrette d'obturation (42) se situe dans le plan de travail du dispositif de fabrication,
balayage d'au moins une ouverture d'obturation de la barrette d'étalonnage par le rayonnement du dispositif d'irradiation,
détection d'un signal de sortie (s(t)) du au moins un capteur de surface,
détermination de la position du point central de la au moins une ouverture d'obturation dans un système de coordonnées de rayonnement à partir du signal de sortie détecté,
comparaison de la position du point central de la au moins une ouverture d'obturation dans le système de coordonnées de rayonnement avec une position connue du point central de l'ouverture d'obturation dans un système de coordonnées de machine raccordé de façon fixe au champ de construction, et
calcul des données de correction pour le dispositif d'irradiation à partir du résultat de la comparaison,
dans lequel de préférence deux ou plusieurs ouvertures d'obturation de la barrette d'étalonnage sont balayées par le rayonnement du dispositif d'irradiation et leurs positions sont déterminées dans le système de coordonnées de rayonnement, et/ou
la barrette d'étalonnage est déplacée par-dessus le champ de construction de préférence transversalement à sa direction longitudinale, de manière davantage préférée perpendiculairement à sa direction longitudinale, et dans au moins une autre position de la barrette d'étalonnage au moins une ouverture d'obturation est balayée par le rayonnement du dispositif d'irradiation et sa position est déterminée dans le système de coordonnées de rayonnement.

12. Procédé d'étalonnage selon la revendication 11, dans lequel
l'étape de balayage d'au moins une ouverture d'obturation (43) contient une première étape de balayage de l'ouverture d'obturation par le rayonnement (22) du dispositif d'irradiation (22) sous la forme de vecteurs (S) qui se déroulent parallèlement les uns aux autres dans une première direction (x) ou dans leur direction inverse et sont espacés les uns des autres, et une seconde étape de balayage de l'ouverture d'obturation par le rayonnement du dispositif d'irradiation sous la forme de vecteurs qui se déroulent parallèlement les uns aux autres dans une seconde direction (y) ou dans leur direction inverse et sont espacés les uns des autres, dans lequel la seconde direction est transversale, de préférence perpendiculaire à la première direction,
l'étape de détection d'un signal de sortie (s(t)) du au moins un capteur de surface (41) contient, pour chacune des deux étapes de balayage, la détermination d'amplitudes (A) et/ou de longueurs (L) d'impulsions (P) individuelles qui correspondent aux vecteurs, et
l'étape de détermination du point central de l'ouverture d'obturation dans le système de coordonnées de rayonnement pour chacune des deux étapes de balayage contient la mise en place d'une distribution locale des amplitudes et/ou longueurs déterminées et l'exploitation de cette distribution locale.

13. Procédé d'étalonnage selon la revendication 11 ou 12, qui contient en outre, après l'étalonnage du dispositif d'irradiation (20), la mesure d'un diamètre focal d'un rayonnement (22) fourni par le dispositif d'irradiation avec les étapes de :
balayage d'une ouverture d'obturation (43) de la barrette d'étalonnage (31) par le rayonnement du dispositif d'irradiation sous la forme d'un vecteur de balayage (S) qui passe par le point central d'obturation, avec une vitesse de balayage prédéterminée,
mesure d'une durée d'une impulsions (P) du signal de sortie (s(t)) du capteur de surface,
calcul du diamètre focal du rayonnement à partir de la durée mesurée et de la vitesse de balayage prédéterminée.

14. Procédé de fabrication destiné à fabriquer un objet (2) tridimensionnel à l'intérieur d'un champ de construction (8) avec les étapes de :
application d'une couche d'un matériau de construction (15) avec un enducteur (16) par déplacement de l'enducteur par-dessus le champ de construction ;
solidification de la couche du matériau de construction au niveau des emplacements correspondant à la section transversale respective de l'objet par irradiation sélective avec un rayonnement (22) adapté pour solidifier le matériau de construction, de préférence un rayonnement laser, de manière encore plus préférée un rayonnement d'un laser à gaz, à l'intérieur du champ de construction ; et
répétition des étapes d'application et de solidification jusqu'à ce que l'objet tridimensionnel soit finalisé,
dans lequel, au moins une fois avant le procédé de fabrication ou pendant le procédé de fabrication, est exécuté un procédé d'étalonnage selon l'une des revendications 11 à 13.
